# EUROPÄISCHE PATENTANMELDUNG

(11) **EP 0 589 228 A1**
(43) Veröffentlichungstag der Anmeldung: **30.03.1994**
(21) Anmeldenummer: 93113556.0
(22) Anmeldetag: 25.08.1993
(51) Int. Cl.: H03G 3/20

(54) **Hochfrequenz-Leistungsverstärker-Anordnung**

(30) Priorität: 24.09.1992 DE 4231925
(71) Anmelder: Rohde & Schwarz GmbH & Co. KG, D-81671 München (DE)
(72) Erfinder: Herzberg, Ralf, Dipl.-Ing. FH, D-81925 München (DE)
(74) Vertreter: Graf, Walter, Dipl.-Ing.

(57) **Zusammenfassung**

Bei einer Hochfrequenz-Leistungsverstärker-Anordnung bestehend aus mehreren über Entkoppler (B1) parallel geschalteten Leistungsverstärkern (Vi) wird über am Ausgang jedes Verstärkers (Vi) angeordnete Wandler (K) jeweils eine der Ausgangsleistung des jeweiligen Verstärkers entsprechende Regelgröße abgeleitet und die Eingangsleistung der Verstärker wird mittels eines vor dem Eingangs-Entkoppler (B1) angeordneten Stellgliedes in Abhängigkeit von der größten dieser Regelgrößen geregelt.

## Beschreibung

Die Erfindung geht aus von einer Hochfrequenz-Leistungsverstärker-Anordnung laut Oberbegriff des Hauptanspruches.

Hochfrequenz-Leistungsverstärker-Anordnungen dieser Art sind beispielsweise als Senderendstufen von Fernsehsendern bekannt. Solche Verstärkeranordnungen haben die Eigenschaft, daß bei Ausfall eines oder mehrerer Verstärker der Gesamtverstärker mit verminderter Ausgangsleistung weiterarbeitet, dieses Verhalten bei Störung ist beispielsweise für Fernsehsender als sogenannte aktive Reserve sehr erwünscht. Um die Ausgangsleistung oder die Verstärkung solcher Verstärkeranordnungen bedingt durch Temperaturschwankungen oder Aussteuerschwankungen konstant zu halten, können die üblichen Regelschaltungen nicht angewendet werden, denn wenn die Ausgangsleistung einer oder mehrerer Verstärker sinkt, so erhöht die übliche Regelung die Eingangsleistung aller Verstärker gemeinsam bis die alte Ausgangsleistung wieder erreicht ist. Die Folge ist eine Übersteuerung der intakten Verstärker und damit ein Verlust an Linearität der Gesamtanordnung oder sogar die mögliche Zerstörung der Verstärker.

Aus diesem Grunde ist es bei Anordnungen dieser Art bekannt, auf eine Regelung der einzelnen Verstärker ganz zu verzichten und zur Stabilisierung relativ aufwendige Kompensationsmaßnahmen vorzusehen ("Solid State Television Transmitters Performance And Correction", D.A. Culling, IBC-Tagungsband 92, Amsterdam, S. 75,76).

Es ist Aufgabe der Erfindung, eine Hochfrequenz-Leistungsverstärker-Anordnung dieser Art zu schaffen, bei der trotzdem auf konstante Ausgangsleistung und/oder auf konstante Verstärkung geregelt werden kann.

Diese Aufgabe wird ausgehend von einer Anordnung laut Oberbegriff des Hauptanspruches durch dessen kennzeichnende Merkmale gelöst. Vorteilhafte Weiterbildungen ergeben sich aus den Unteransprüchen.

Durch die erfindungsgemäße Regelung besitzt eine Leistungsverstärkeranordnung gutes Störverhalten, bei Ausfall eines oder mehrerer Verstärker wird stets die maximal mögliche Ausgangsleistung geliefert und trotzdem eine Übersteuerung der verbleibenden Verstärker vermieden. Die erfindungsgemäße Regelanordnung kann mit beliebig großem Regelbereich auf sehr einfache Weise realisiert werden, alle Verstärker sind immer in die Regelung eingebunden. Damit wird auch eine große Betriebssicherheit erreicht. Die erfindungsgemäße Regelung eignet sich sowohl zum Regeln auf konstante Ausgangsleistung als auch zum Regeln auf konstante Verstärkung der Gesamtanordnung.

Mit der erfindungsgemäßen Regelanordnung kann eine solche Leistungsverstärkeranordnung auch auf sehr einfache Weise gegen Überschreitung von beliebigen Störgrößen geschützt werden, dazu ist es nur erforderlich, zusätzlich noch eine dieser Störgröße proportionale Regelgröße abzuleiten und diese mit den anderen gewonnenen Regelgrößen der einzelnen Verstärker in die Regelung mit einzubeziehen. Damit kann auf besonders einfache Weise beispielsweise die Gesamtverstärkeranordnung gegen Fehlabschlüsse am Ausgang (zu große Reflexion am Verstärkerausgang) oder gegen unzulässig hohen Effektivwert des Ausgangssignals geschützt werden.

Die Erfindung wird im folgenden anhand einer schematischen Zeichnung an Ausführungsbeispielen näher erläutert.

Die Fig. zeigt das Prinzipschaltbild einer Hochfrequenz-Leistungsverstärker-Anordnung, wie sie beispielsweise zum Erzeugen einer hohen Ausgangsleistung bei einem Fernsehsender Anwendung findet. Über Koppler B1 und B2, beispielsweise entkoppelnde Brücken wie Wilkinson-Koppler, sind mehrere einzelne Hochfrequenz-Leistungsverstärker V1 bis Vₙ, beispielsweise übliche Transistorverstärker, parallel geschaltet. Diese einzelnen VerstärkerV1 bis Vn sind gleich aufgebaut und in ihren Verstärkungseigenschaften praktisch identisch. Die Eingangsleistung P1 wird über ein Stellglied S, beispielsweise ein elektronisches Dämpfungsglied und eventuell einen Treiberverstärker T dem Eingang des Kopplers B1 zugeführt, die Ausgangsleistungs P2 am Ausgang des Kopplers B2 ist die Summe aller Leistungen der einzelnen Verstärker V1 bis Vₙ.

Am Ausgang jedes Verstärkers V1 bis Vₙ ist jeweils ein Wandler bestehend aus einem Richtkoppler K mit nachgeschaltetem Gleichrichter G angeschaltet, die Ausgänge dieser Gleichrichter G sind über ein Entkopplungsnetzwerk N, hier z.B. gebildet aus den Dioden D, am Eingang E eines Reglers L zusammengefaßt.

Die Gleichrichter G sind beispielsweise als Spitzenwertgleichreichter ausgebildet, sie können jedoch auch als Effektivwertgleichrichter ausgebildet sein. Über diese Wandler wird für jeden einzelnen Verstärker V1 bis Vₙ am Ausgang jedes Gleichrichters eine von der Ausgangleistung dieses Verstärkers jeweils abhängige Analogspannung U1 bis Un erzeugt, beispielsweise also die der Spitzenleistung am Ausgang jedes Verstärkers entsprechende Spitzenspannung U1 bis Un. Über das Entkopplungsnetzwerk N werden diese Gleichspannungen dem Eingangswiderstand R des Reglers zugeführt und an diesem Widerstand R entsteht also so eine Regelspannung U, die dem größten Spannungswert der Spannungen U1 bis Un entspricht, diese Regelgröße U entspricht also der Ausgangsleistung des Verstärkers V1 bis Vn mit der höchsten Ausgangsleistung. Diese Regelgröße U wird im Regler L beispielsweise mit einer Referenzspannung Usoll verglichen und so am Ausgang des Reglers L eine Stellgröße Ustell erzeugt, mit welcher das Stellglied S verstellt wird. Die Referenzspannung Usoll wird beispielsweise durch Rechnung aus den Angaben der jeweils verwendeten Verstärker V1 bis Vn ermittelt und entspricht dem nominalen Soll-Ausgangsleistungswert jedes einzelnen Verstärkers. Durch Vergleich der Regelgröße U mit der festen konstanten Referenzspannung Usoll wird so die Eingangsleistung P1' am Eingang des Entkopplers B1 über das Stellglied S so geregelt, daß U = Usoll ist, damit wird auf konstante Ausgangsleistung geregelt und zwar auf denjenigen Wert, der dem Verstärker mit der jeweils größten Einzelausgangsleistung entspricht. Wenn die Ausgangsleistung eines oder mehrerer der Verstärker V1 bis Vn durch Fehler absinkt oder ein oder mehrere Verstärker ganz ausfallen, ändert sich die Regelspannung U praktisch nicht, da die Spannungen U1 bis Un über die Dioden D voneinander entkoppelt sind und jeweils nur die größte Spannung am Widerstand R abfällt. Der Regler bemerkt also einen eventuellen Ausfall eines oder mehrerer Verstärker nicht sondern regelt auf die Ausgangsleistung des verbliebenen Verstärkers mit der größten Ausgangsleistung, die Eingangsleistung P1' ändert sich durch den Störfall praktisch nicht. Über den Entkoppler B1 erhält jeder Verstärker weiterhin seine ihm zugehörige Eingangsleistung, obwohl die Ausgangsleistung P2 bei Ausfall eines oder mehrerer Verstärker entsprechend absinkt. Die verbleibende Ausgangsrestleistung P2 ist also stets die maximal mögliche Rest-Leistung der Gesamtanordnung.

Eine andere Möglichkeit besteht darin, mit dieser Regelschaltung auf konstante Gesamtverstärkung der Anordnung zu regeln, dazu wird beispielsweise wiederum über einen Wandler W1 bestehend aus einem Richtkoppler und einem Gleichrichter die Eingangsleistung P1 am Eingang des Gesamtverstärkers in eine entsprechende Gleichspannung, beispielsweise wiederum den Spitzenwert dieser Eingangsleistung, umgesetzt und als Sollgröße dem Regler L zugeführt, wie dies durch die gestrichelt dargestellte Wirkverbindung dargestellt ist. Damit wird dann automatisch auf konstante Verstärkung geregelt.

Mit der erfindungsgemäßen Regelschaltung kann die Gesamtverstärkeranordnung auch auf einfache Weise gegen ein Überschreiten beliebig anderer Störgrößen des Verstärkers geschützt werden, beispielsweise gegen einen Fehlabschluß am Ausgang des Ausgangs-Entkopplers B1. Dazu ist es nur erforderlich, dem Ausgang einen weiteren Richtkoppler K1 zuzuordnen und am Rücklauf-Ausgang dieses Richtkopplers K1 einen Spitzenwertgleichrichter G1 anzuordnen, der damit eine der reflektierten Leistung der Gesamtverstärkeranordnung entsprechenden Spitzenspannungswert U_{REFL} liefert, der einer weiteren Diode D des Entkoppelnetzwerkes zugeführt wird. Wenn die Fehlanpassung am Ausgang des Entkopplers B2 und damit die reflektierte Leistung und somit auch der davon abgeleitete Spitzenspannungswert U_{REFL} einen vorbestimmten Grenzwert überschreitet, der größer ist als eine der Spannungen U1 bis Un, so wird dieser Spitzenspannungswert U_{REFL} am Widerstand R zur Regelung des Reglers L benutzt und so über das Stellglied S der Ausgangsleistung heruntergeregelt, bis der vorbestimmte Grenzwert wieder unterschritten ist. Der Verstärker wird so bei zu großer Fehlanpassung gegen Überlastung geschützt.

Eine andere Möglichkeit besteht darin, den Gesamtverstärker gegen einen unzulässig hohen Effektivwert des Ausgangssignals durch fehlerhafte Kurvenform von amplitudenmodulierten Signalen zu schützen, wie dies beispielsweise bei der Verstärkung von Fernsehsignalen bei Wegfall des Synchronimpulses der Fall sein kann. Dazu wird am Ausgang des Entkopplers B2 wieder ein Richtkoppler K2 angeordnet, mit dem Vorlauf-Ausgang dieses Richtkopplers K2 ist ein Effektivwertgleichrichter G2 verbunden, der somit eine dem Effektivwert des Ausgangssignales der Gesamtverstärkeranordnung entsprechende Effektivwertspannung U_{EFF} liefert, die wiederum über eine Diode dem Entkoppelnetzwerk N zugeführt wird. Ist dieser so gewonnene Effektivwert U_{EFF} größer als eine der in diesem Fall über Spitzenwertgleichrichter G gewonnene Spitzenspannungswerte U1 bis Un, so übernimmt wieder diese größte Regelgröße U_{EFF} die Regelung und die Eingangsleistung der Gesamtverstärkeranordnung wird über das Stellglied S herabgeregelt, so daß der Verstärker gegen unzulässig hohen Effektivwert geschützt ist. Die Spannungen U_{REFL} und U_{EFF} könnten auch ähnlich wie die Spannungen U1 bis Un für jeden Verstärker einzeln erzeugt und über das Entkoppelnetzwerk N auf den Widerstand R geführt werden.

Der Verstärker könnte in gleicher Weise auch gegen andere Störgrößen, beispielsweise die Temperatur, geschützt werden, indem über einen Temperaturwandler eine der Temperatur entsprechende Regelspannung gewonnen und dem Entkoppelnetzwerk N zugeführt wird, wenn der Verstärker auf eine zu hohe Temperatur erwärmt wird übernimmt wieder diese damit größte Temperatur-Regelgröße die Regelung der Ausgangsleistung und der Verstärker wird so gegen Überhitzung geschützt.

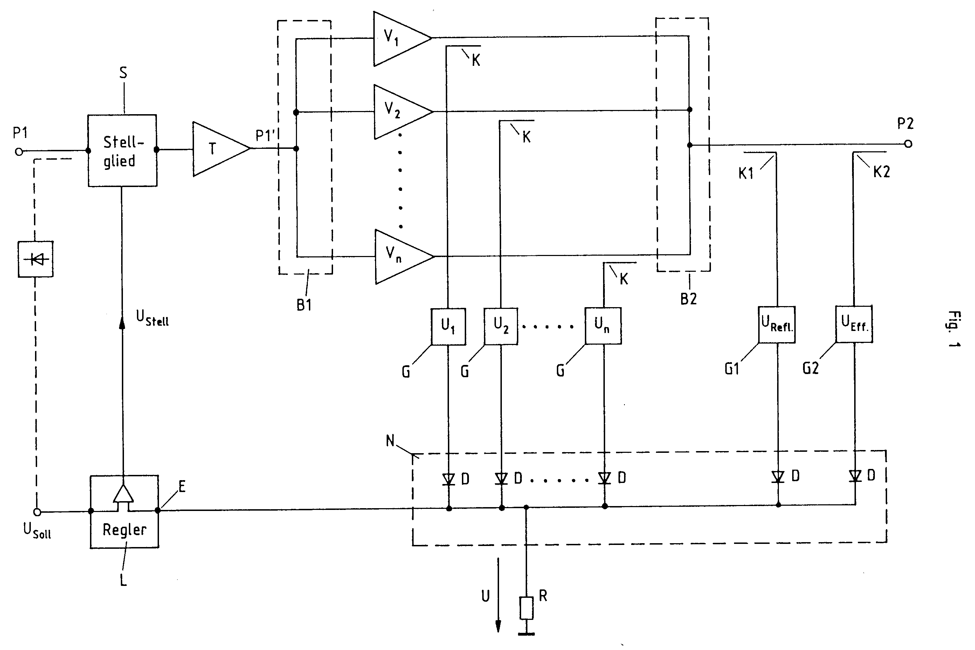

## Patentansprüche

1. Hochfrequenz-Leistungsverstärker-Anordnung bestehend aus mehreren über Entkoppler (B1, B2) parallel geschalteten Leistungsverstärkern (V1 bis Vn), dadurch **gekennzeichnet,** daß über am Ausgang jedes einzelnen Verstärkers (V1 bis Vn) angeordnete Wandler (K, G) jeweils eine der Ausgangsleistung des jeweiligen Verstärkers entsprechende Regelgröße (U1 bis Un) abgeleitet wird und die Eingangsleistung (P1') der Gesamtverstärkeranordnung mittels eines vor dem Eingangs-Entkoppler (B1) angeordneten Stellgliedes (S) in Abhängigkeit von der größten (U) dieser Regelgrößen (U1 bis Un) geregelt ist.

2. Anordnung nach Anspruch 1, dadurch **gekennzeichnet,** daß die jeweils größte Regelgröße (U) in einem Regler (L) mit einer vorgegebenen konstanten Sollgröße (Usoll) verglichen wird und mit der Stellgröße (Ustell) des Reglers (L) über das Stellglied (S) auf konstante Ausgangsleistung der Anordnung geregelt wird.

3. Anordnung nach Anspruch 1 oder 2, dadurch **gekennzeichnet,** daß die jeweils größte Regelgröße (U) in einem Regler (L) mit einer der Eingangsleistung (P1) entsprechenden Sollgröße verglichen wird und mit der Stellgröße (Ustell) des Reglers (L) über das Stellglied (S) auf konstante Verstärkung der Anordnung geregelt wird.

4. Anordnung nach einem der vorhergehenden Ansprüche, dadurch **gekennzeichnet,** daß über mindestens einen weiteren Wandler (K1, G1; K2, G2) eine einer weiteren Störgröße der Gesamtverstärkeranordnung entsprechende Regelgröße (U_{REFL}, U_{EFF}) gewonnen wird und die Eingangsleistung (P1') der Gesamtverstärkeranordnung in Abhängigkeit von der größten aller so gewonnenen Regelgrößen (U1 bis Un, U_{REFL}, U_{EFF}) geregelt wird.

5. Anordnung nach Anspruch 4, dadurch **gekennzeichnet,** daß über einen nach dem Ausgangs-Entkoppler (B2) angeordneten Wandler (K1, G1) eine der reflektierenden Leistung der Gesamtverstärkeranordnung entsprechende Regelgröße (U_{REFL}) abgeleitet wird.

6. Anordnung nach Anspruch 4 oder 5, dadurch **gekennzeichnet,** daß über einen nach dem Ausgangs-Entkoppler (B2) angeordneten Wandler (K2, G2) eine dem Effektivwert der Gesamtverstärkeranordnung entsprechende Regelgröße (U_{EFF}) abgeleitet wird.

7. Anordnung nach einem der vorhergehenden Ansprüche, dadurch **gekennzeichnet,** daß die Wandler jeweils aus einem Richtkoppler (K, K1, K2) mit nachgeschaltetem Gleichrichter (G, G1, G2) bestehen und die Regelgröße jeweils eine Gleichspannung (U1 bis Un, U_{REFL}, U_{EFF}) ist.

8. Anordnung nach Anspruch 1 und 7, dadurch **gekennzeichnet,** daß die Richtkoppler (K) der Wandler jeweils mit dem Ausgang der einzelnen Leistungsverstärker (V1 bis Vn) gekoppelt sind.

9. Anordnung nach Anspruch 8, dadurch **gekennzeichnet,** daß die Gleichrichter (G) Spitzenwertgleichrichter sind und damit eine dem Spitzenwert der Ausgangsleistung der einzelnen Leistungsverstärker (V1 bis Vn) entsprechender Spitzenspannungswert (U1 bis Un) als Regelgröße abgeleitet wird.

10. Anordnung nach Anspruch 4, 5 und 7, dadurch **gekennzeichnet,** daß der Richtkoppler (K1) des Wandlers mit dem Ausgang des Ausgangs-Kopplers (B2) gekoppelt ist und der als Spitzenwertgleichrichter ausgebildete Gleichrichter (G1) mit dem Rücklauf-Ausgang dieses Richtkopplers (K1) verbunden ist.

11. Anordnung nach einem der vorhergehenden Ansprüche, dadurch **gekennzeichnet,** daß die Ausgänge der Gleichrichter (G, G1, G2) sämtlicher Wandler in einem Entkoppelnetzwerk (N) zusammengefaßt sind und über den Ausgang dieses Entkoppelnetzwerkes die jeweils größte Gleichspannung (U) dem Regler (L) zugeführt wird.
